# EUROPÄISCHE PATENTSCHRIFT

(11) **EP 2 155 403 B1**
(45) Veröffentlichungstag und Bekanntmachung des Hinweises auf die Patenterteilung: **06.10.2010**
(21) Anmeldenummer: 08758660.8
(22) Anmeldetag: 20.05.2008
(51) Int. Cl.: C23C 2/04, C03C 17/00, C03C 17/22, H01L 31/18

(54) **VERFAHREN ZUR OBERFLÄCHENMODIFIKATION VON FLACHEN SUBSTRATEN**
METHOD FOR THE SURFACE MODIFICATION OF FLAT SUBSTRATES
PROCÉDÉ DE MODIFICATION DE LA SURFACE DE SUBSTRATS PLANS

(30) Priorität: 25.05.2007 DE 102007024667
(43) Veröffentlichungstag der Anmeldung: 24.02.2010
(73) Patentinhaber: RENA GmbH, 78148 Gütenbach (DE)
(72) Erfinder: KALTENBACH, Konrad, 78120 Furtwangen (DE); SCHIENLE, Frank, 79111 Freiburg (DE); BALDUS, Andreas, 79283 Bollschweil (DE); BARBAR, Ghassan, 79194 Wildtal (DE)
(74) Vertreter: Stürken, Joachim
(86) Internationale Anmeldenummer: PCT/EP2008/004053
(87) Internationale Veröffentlichungsnummer: WO 2008/145285

(56) Entgegenhaltungen:
- EP-A- 0 949 010
- US-A- 4 004 045
- US-A- 4 353 942

## Beschreibung

Die Erfindung betrifft allgemein das einseitige nasschemische Modifizieren von Substratoberflächen, genauer das einseitige nasschemische Beschichten von flachen Substraten. Insbesondere betrifft die vorliegende Erfindung ein Verfahren zum Beschichten von Substraten im Rahmen der Herstellung von Dünnschicht-Solarzellen oder -modulen aus Glas, Metall oder Kunststoff mit metallischen Verbindungen wie beispielsweise Cadmiumsulfid oder Zinksulfid.

Zum Beschichten ebener Flächen ist aus dem Stand der Technik eine Vielzahl unterschiedlichster Verfahren und Vorrichtungen bekannt, deren Auswahl vor allem von der Art und Dicke der gewünschten Beschichtung sowie von der Beschaffenheit bzw. Struktur des zu beschichtenden Substrates abhängig ist. Beispielsweise kann zwischen stromvermittelter oder stromloser Abscheidung, sowie zwischen einer Abscheidung aus der Gas-oder Flüssigphase, als auch zwischen Hoch- bzw. Niedertemperaturverfahren unterschieden werden. Insbesondere bei der Herstellung von Solarzellen erfolgen zumeist mehrere Beschichtungen der Trägerstrukturen bzw. Substrate wie z.B. von Glasplatten, um den Zellen die nötige Stabilität sowie gewünschte Eigenschaften zu verleihen. Ein besonders viel versprechendes Verfahren nutzt so genannte CIS-Schichten, die sich durch eine hohe Lichtabsorption auszeichnen. Dazu werden üblicherweise auf ein Substrat einseitig zunächst der Rückkontakt, meistens aus Molybdän (Mo) mit einer Schichtdicke zwischen 0,5 und 1 µm, und anschließend eine 1-2 µm dünne Schicht aus Kupfer-Indium-Sulfid, Kupfer-Indium-Diselenid, Kupfer-Gallium-Sulfid oder Kupfer-Gallium-Diselenid (allgemein mit CI(G)S(Se) bezeichnet) aufgebracht, bevor diese entsprechend modifizierte Seite des Substrates in einem anschließenden Schritt mit einer so genannten sulfidischen Pufferschicht wie z.B. mit Cadmiumsulfid (CdS) oder Zinksulfid (ZnS) beschichtet wird. Als Ausgangsstoffe werden dabei gewöhnlich Cadmium bzw. Zink enthaltende Verbindungen und Salze wie zum Beispiel Cadmium- oder Zinksulfat bzw. -acetat, sowie Thioharnstoff (THS, CH₄N₂S) und Ammoniak (NH₄OH) benutzt, die zunächst getrennt gelagert und erst kurz vor der Beschichtung im gewünschten Verhältnis miteinander vermischt werden. Die aus der Beschichtung resultierende dünne CdS- bzw. ZnS-Schicht, welche allgemein eine Dicke zwischen 30 und 90 nm und insbesondere zwischen 30 und 60 nm aufweist, sollte hinsichtlich ihrer Struktur, Dicke und Zusammensetzung zur Erreichung eines optimalen Wirkungsgrades möglichst homogen beschaffen sein und fest auf der zuvor aufgebrachten CI(G)S(Se)-Schicht haften. Die zu beschichtenden Substrate haben dabei typische Maße von 1.200 mm Länge und 600 mm Breite sowie 3 mm Dicke, während die Gesamtheit der Beschichtungen selber nur eine Dicke vom Nanometer- bis in den Mikrometerbereich aufweist. Zukünftig sind jedoch aus Gründen der Kostenoptimierung noch größere Substratflächen gewünscht.

Es ist bekannt, dass eine wirksame Abscheidung von CdS oder ZnS auf der Oberfläche eines Substrats nur innerhalb eines bestimmten Temperaturbereichs, der etwa zwischen Raumtemperatur bzw. 30° und etwa 95°C liegt, stattfinden kann. Bei der Anwendung nasschemischer Beschichtungsverfahren unter Verwendung eines Behandlungsbeckens muss daher darauf geachtet werden, dass die Temperatur der im Bad befindlichen Flüssigkeit sowohl insgesamt als auch im Kontaktbereich mit der zu behandelnden Fläche akkurat gesteuert wird, damit die zur Auslösung der gewünschten Abscheidung erforderliche Minimaltemperatur von etwa 20 bis 30°C erreicht wird, ohne jedoch die Temperatur im Flüssigkeitsbad derart ansteigen zu lassen, so dass es zu den im Stand der Technik beschriebenen unerwünschten Reaktionen (z.B. Kolloidbildung) kommt, die das Beschichtungsergebnis gefährden und einen erhöhten Verbrauch an Flüssigkeit sowie gegebenenfalls die Notwendigkeit anschließender Bearbeitungsschritte wie z.B. solchen zur Reinigung nach sich ziehen. Um dieser Problematik zu begegnen, hat der Stand der Technik z.B. Alternativen entwickelt, bei denen die zu beschichtende Substratseite nicht mehr in ein Beschichtungsbad überführt, sondern manuell oder automatisch mit der Flüssigkeit benetzt wird. Zur Erzeugung einer möglichst gleichmäßigen, die Reaktion unterstützenden Temperatur wird das Substrat z.B. mit der nicht zu beschichtenden Unterseite in ein entsprechend temperiertes Wasserbad überführt und auf der Oberfläche desselben abgelegt. Nachdem sich das Substrat bis zu seiner zu behandelnden Oberseite ausreichend erwärmt hat, wird die die chemischen Bestandteile umfassende flüssige Zusammensetzung von oben auf die Substratoberfläche aufgebracht, wodurch die Ausbildung der gewünschten Schicht induziert wird.

Aus dem Stand der Technik sind daher vor allem solche Anlagen bekannt, bei welchen eine die gewünschte Beschichtung der Substrate herbeiführende flüssige Zusammensetzung einseitig von oben auf die Trägerstrukturen appliziert wird.

Derartige Anlagen haben jedoch eine Reihe von Nachteilen. So ist es beispielsweise häufig nicht erwünscht, dass neben der Oberseite auch die Kanten der Substrate mit der Behandlungsflüssigkeit benetzt werden. Hierzu sind entsprechend aufwändige bzw. präzise Applikationstechniken nötig, um ein seitliches Herunterlaufen der Behandlungsflüssigkeit zu vermeiden. Zu diesem Zweck werden zumeist umlaufende Dichtringe eingesetzt, die auch sicherstellen müssen, dass die Behandlungsflüssigkeit nicht in das Wasserbad gelangt, was zur Kontamination des Wasserbads führt. Ferner muss die Oberseite mit der aufgetragenen Flüssigkeit gegenüber der Umgebung abgeschirmt werden, um Verunreinigungen des Substrates sowie eine Gefährdung des Anwenders auszuschließen. Auch die genaue Dosierung der Behandlungsflüssigkeit muss jederzeit reproduzierbar sichergestellt sein, da es ansonsten zu unterschiedlichen Schichtdicken und/oder zu unterschiedlich ausgeprägten und daher inhomogenen Schichten kommt, wodurch die funktionellen Eigenschaften wie z.B. der Wirkungsgrad des späteren Verfahrenserzeugnisses beeinträchtigt werden kann. Eventuell überschüssige Mengen an Behandlungsflüssigkeit müssen abgeführt und aufbereitet oder entsorgt werden. Es kommt hinzu, dass bei der Verwendung eines Wasserbades zum Aufheizen lediglich eine relativ langsame Temperaturerhöhung erfolgt, da die Temperatur des Wassers aufgrund der sonst zunehmenden Blasen- und Dampfbildung deutlich unter 100 °C liegen muss und somit die Menge der zugeführten Wärme begrenzt ist. Weiterhin muss die durch das Wasser des Wasserbades benetzte Substratseite nach der Behandlung wieder getrocknet werden, was einen zusätzlichen Behandlungsschritt erfordert und das Risiko einer trocknungsbedingten Ablagerung unerwünschter Stoffe beinhaltet. Schließlich fertigen derartige Anlagen im so genannten "Batch"-Verfahren, also diskontinuierlich im Stapelverfahren, was den Durchsatz begrenzt und insbesondere im Hinblick auf hohe und höchste Stückzahlen unerwünscht ist. Aus dieser diskontinuierlichen Behandlung resultiert insbesondere auch ein großer mechanischer und fluidischer Handhabungsaufwand, der zu entsprechend hohen Kosten und einer Verlängerung der Behandlungsdauer führt.

Die Aufgabe der vorliegenden Erfindung liegt daher in der Bereitstellung eines Verfahrens zur einseitigen nasschemischen Oberflächenmodifikation wie insbesondere Beschichtung flacher Substrate, mit welchem die Probleme des Standes der Technik überwunden werden. Erfindungsgemäß soll das Verfahren ein Höchstmaß an Homogenität sicherstellen und kontinuierlich, d.h. im Rahmen einer "Tnline"-Prozessierung auf flache Substrate derart angewendet werden können, dass die nicht zu behandelnde Seite während der Behandlungsdauer nicht mit einer wärmenden Flüssigkeit benetzt wird. Ferner soll das Verfahren eine einseitige Oberflächenmodifikation oder Beschichtung derart ermöglichen, dass das Substrat nicht von oben, wie beispielsweise durch eine Vakuumhalteeinrichtung, gehalten oder vor einer Benetzung durch die Behandlungsflüssigkeit geschützt wird.

Zur Lösung der Aufgabe wird das Verfahren gemäß Hauptanspruch bereitgestellt. Bevorzugte Ausführungsformen sind Gegenstand der Unteransprüche, der nachfolgenden Beschreibung sowie der Figur.

Die Erfindung betrifft ein Verfahren zur einseitigen nasschemischen Oberflächenmodifikation wie z.B. zum einseitigen nasschemischen Beschichten eines im Wesentlichen flachen Substrates, wie z.B. einer Glas-, Metall- und/oder Kunststoffplatte bzw. -folie, unter Verwendung einer in einem Behandlungsbecken befindlichen Flüssigkeit, deren chemische Bestandteile durch geeignete Temperatursteuerung auf der Substratfläche unter Ausbildung einer dauerhaften Schicht abgeschieden werden. Die zur Ausbildung der gewünschten Schicht notwendige Erwärmung der zu beschichtenden Substratunterseite erfolgt erfindungsgemäß durch mindestens ein geeignetes Mittel zur Erwärmung, das bevorzugt außerhalb der Flüssigkeit oder des Behandlungsbeckens angeordnet ist und das Substrat von seiner nicht zu beschichtenden Oberseite her auf die erforderliche Temperatur erwärmt. Erfindungsgemäß ist vorgesehen, dass die nicht zu behandelnde Oberseite während der Behandlung mit keiner wärmenden Flüssigkeit benetzt wird, weshalb sie also weder mit der Behandlungsflüssigkeit noch mit einer anderen wärmenden Flüssigkeit zur Wärmeübertragung in Kontakt kommt. Da erfindungsgemäß bevorzugt sogar jedwede Benetzung der nicht zu behandelnden Seite unterbleibt, entfällt auch eine damit verbundene Notwendigkeit der nachträglichen Entfernung der Flüssigkeit bzw. Trocknung der nicht zu behandelnden Substratfläche. Erfindungsgemäß ist ferner vorgesehen, dass das Substrat während der Behandlung weder von oben gehalten noch geschützt wird, sodass das Substrat lediglich auf mindestens einer geeigneten Auflage einer zur Duchführung des Verfahrens geeigneten Vorrichtung aufliegt und auf die Verwendung eines Halters wie z.B. eines Vakuum-Spannfutters verzichtet werden kann.

Gewünschtenfalls kann erfindungsgemäß eine Modifikation oder Beschichtung der Unterseite einschließlich der umlaufenden Substratkante vorgenommen werden.

Besonders bevorzugt kann das erfindungsgemäße Verfahren im Rahmen der Herstellung von Dünnschicht-Solarzellen oder -modulen aus Glas, Metall und/oder Kunststoff eingesetzt werden, wobei die vorzugsweise wässrige Behandlungsflüssigkeit Cadmium- oder Zinksulfat bzw. -acetat, sowie eine Schwefelquelle wie z.B. Thioharnstoff (THS, CH₄N₂S) und eine Stickstoffquelle wie z.B. Ammoniak (NH₄OH) umfasst. Am meisten bevorzugt wird eine Behandlungsflüssigkeit eingesetzt, in der die Konzentrationen der Reaktionsteilnehmer etwa 0,1 mol/l Cadmium- bzw. Zinksulfat, max. 1 mol/l THS und etwa 16 mol/l Ammoniak betragen. Derartige Behandlungsflüssigkeiten sind im Stand der Technik bekannt und können vom Fachmann leicht bereitgestellt werden.

Das Verfahren ist jedoch weder auf diese Behandlungsflüssigkeit, noch auf diesen Anwendungsfall beschränkt. Neben der Beschichtung von festem Plattenmaterial kann das erfindungsgemäße Verfahren auch zu einer Beschichtung von flexiblem Rollen- bzw. Folienmaterial wie z.B. von Polyimid- oder Edelstahlfolien genutzt werden. Als Werkstoffe kommen neben den oben genannten auch Schichtaufbauten derselben miteinander und mit anderen in der Photovoltaik üblichen Element- oder Verbindungshalbleitern wie beispielsweise Si, Ge, CdTe oder auch leitende Polymere in Betracht. Beispielsweise kann das erfindungsgemäße Verfahren auch bei der Fertigung von organischen Leuchtdioden (OLEDs) angewendet werden.

Dem Fachmann ist klar, dass sich die vorliegende Erfindung sowohl zur stromlosen als auch zur stromvermittelten Beschichtung flacher Substrate der genannten Art eignet, wenngleich die stromlose Beschichtung vorliegend bevorzugt ist.

Um eine Beschichtung mit einer möglichst hohen und gleich bleibenden Qualität zu erreichen, wird die Zusammensetzung und/oder die Temperatur der Behandlungsflüssigkeit nach einer bevorzugten Ausführungsform des Verfahrens kontinuierlich überwacht und bei Bedarf nachgeregelt.

Zur Überwachung der Zusammensetzung der Behandlungsflüssigkeit kommen je nach Anwendungsfall entsprechend geeignete Mittel wie z.B. Sensoren zum Einsatz, die besonders bevorzugt mit einer Regeleinrichtung gekoppelt sind. Diese Regeleinrichtung steuert gegebenenfalls die Einspeisung der Reaktionsteilnehmer in die Behandlungsflüssigkeit. Alternativ oder zusätzlich können der Flüssigkeit vorzugsweise zu bestimmten Zeiten der Behandlungsdauer oder auch zwischen der aufeinanderfolgenden Behandlung mehrerer Substrate Proben zur Bestimmung der jeweiligen Mischungsverhältnisse und/oder Konzentrationen der Reaktionsteilnehmer entnommen werden, sodass anhand der Ergebnisse nachgeregelt werden kann.

Zur Überwachung des gewünschten Temperaturbereichs der Behandlungsflüssigkeit wie insbesondere zur Einhaltung der für den Anwendungszweck vorgesehenen maximalen Temperatur können ebenfalls entsprechend geeignete Mittel wie z.B. Sensoren verwendet werden, welche wiederum besonders bevorzugt mit einer weiteren Regeleinrichtung gekoppelt sind, mit der z.B. die Ventile eines Vorratsbehälters mit gekühlter Behandlungsflüssigkeit gesteuert werden können.

Nach einer weiteren bevorzugten Ausführungsform liegt das Substrat auf einem geeigneten Transportmittel auf und wird mit seiner zu beschichtenden Unterseite während der Behandlung kontinuierlich über oder durch die Flüssigkeit transportiert. Der Transport erfolgt dabei besonders bevorzugt derart, dass ausschließlich die Unterseite des Substrats mit der Behandlungsflüssigkeit in Kontakt kommt. Nach dieser Ausführungsform kann das Verfahren im Rahmen einer kontinuierlichen "Inline"-Fertigung zur Bearbeitung größerer Stückzahlen bei vergleichsweise geringen Taktzeiten angewendet werden.

Nach einer weiteren bevorzugten Ausführungsform des Verfahrens werden mehrere Mittel zur Erwärmung des Substrates eingesetzt, deren Wärmeabgabe auf das Substrat oder deren Leistung unabhängig voneinander gesteuert werden kann. Diese Steuerung kann durch einfaches Ein- und Ausschalten der jeweiligen Mittel, durch Regeln der Höhe der auf das Substrat einwirkenden Wärmemenge oder Leistung, und/oder durch Einbringen von geeigneten Blenden bzw. Filtern in den Strahlengang erfolgen.

Für den Fall einer statischen Behandlung ohne oder mit stillstehendem Transportmittel wird die Substratunterseite im Verlauf ihrer Beschichtung vorzugsweise gleichmäßig auf unterschiedliche Temperaturen erwärmt, wodurch ein besonders gutes Beschichtungsergebnis erzielt werden kann. Erfindungsgemäß konnte gezeigt werden, dass die Beschichtung eines Substrates, auf dessen Unterseite während der Behandlungsdauer unterschiedliche Temperaturen einwirken, sogar höchsten Qualitätsanforderungen entspricht, und zwar insbesondere dann, wenn zu Beginn der Behandlung eher niedrige Temperaturen, im weiteren Verlauf derselben eher höhere Temperaturen an der Substratunterseite anliegen. Im Ergebnis erhält man auf diese Art und Weise im Vergleich zu einer gleich bleibend hohen Reaktionstemperatur eine feinere und gleichmäßigere Abscheidung an der zu beschichtenden Substratoberfläche. Für den Fall einer Behandlung mit kontinuierlichem Transport des Substrates werden die Mittel zur Erwärmung vorzugsweise derart unabhängig voneinander gesteuert, dass die zu beschichtende Substratunterseite während ihres Transports über oder durch die Flüssigkeit unterschiedlich erwärmt wird und damit in Transportrichtung ein vorgegebenes Temperaturprofil durchläuft oder erfährt. So kann die jeweilige Leistung der Mittel zur Erwärmung auch so eingestellt werden, dass sie, in Transportrichtung des Behandlungsbeckens gesehen, jeweils an unterschiedlichen Orten desselben unterschiedlich starke Wärmemengen auf das Substrat abgeben oder in diesem induzieren, so dass beispielsweise am Beginn des Bades eine verringerte, und im mittleren Bereich des Bades die volle Wärmeleistung anliegt. Somit kann der oben beschriebene Effekt aus der Einwirkung unterschiedlicher Temperaturen auf die Substratunterseite auch bei kontinuierlicher Prozessierung erreicht werden. Im Gegensatz zu Vorrichtungen des Standes der Technik, bei welchen das Durchfahren eines Temperaturprofils beim Aufheizen - wenn überhaupt - nur sehr eingeschränkt möglich und dann nur mit entsprechend langen Reaktionszeiten zu erreichen ist, erfolgt erfindungsgemäß eine zügige und auch örtlich gut steuerbare Wärmeabgabe an das bzw. Wärmeinduktion im Substrat.

Besonders bevorzugt erfolgt die Steuerung der Mittel zur Erwärmung derart, dass das zuvor erwähnte Temperaturprofil im Falle eines kontinuierlichen Transports des Substrates in einer senkrecht zur Transportrichtung liegenden Schnittebene des Substrates über die gesamte Breite desselben und insbesondere im Bereich seiner zu beschichtenden Unterseite weitgehend konstant ist. Vorteilhafterweise sollte die Temperaturabweichunq im Bereich der Substratunterseite ±1% oder weniger betragen.

Anstelle einer direkten Ansteuerung der Mittel zur Erwärmung können diese jederzeit eine unveränderliche Menge an Wärme abstrahlen, die jedoch durch weitere Mittel wie Blenden oder Filter so abgeschwächt und/oder durch Spiegel oder Linsen so konzentriert werden kann, dass sich an der zu beschichtenden Substratoberfläche die gewünschte Wärmeverteilung ergibt.

Nach einer weiteren Ausführungsform wird das mindestens eine Mittel zur Erwärmung des Substrates aus der Gruppe bestehend aus Wärmestrahlern, Wärmeüberträgern, Wärmeinduktoren und Kombinationen derselben ausgewählt. Während Wärmestrahler keinen direkten Kontakt zum Substrat haben und die Wärme auf das Substrat ausschließlich über Strahlung, vorzugsweise im langwelligen Infrarotbereich, übertragen wird, stehen Wärmeüberträger, zu denen neben Festkörpern auch Gase wie z.B. Heißluft zählen, in direktem, körperlichen Kontakt mit der nicht zu behandelnden Oberseite, wo sie die Wärme in Form von Wärmeübertragung an das Substrat abgeben. Wärmeinduktoren schließlich stellen nicht die Wärme selber bereit, sondern liefern, beispielsweise per Strahlung, eine Energiemenge, welche dann im Substrat oder an seiner Oberfläche in Wärmeenergie transformiert wird, wozu vom Substrat entsprechende Absorber umfasst sein müssen. Obwohl diese Wärmeinduktoren daher keine Wärme als solche bereitstellen, fallen sie vollständig unter die erfindungsgemäße Gruppe der Mittel zur Erwärmung, da sie ebenfalls die gewünschte Erwärmung der zu modifizierenden oder beschichtenden Substratseite herbeiführen. Daher gelten die vorliegenden allgemeinen und bevorzugten Ausführungen zur Anzahl, Positionierung und Steuerung des mindestens einen Mittels zur Erwärmung ausdrücklich auch für die Wärmeinduktoren. Erfindungsgemäß bevorzugt sind die Wärmestrahler und Wärmeinduktoren sowie Kombinationen derselben, weil nur diese Mittel die Möglichkeit bieten, eine selektive Erwärmung der Substratunterseite durch den Substratkörper hindurch zu erreichen, und zwar insbesondere dann, wenn die Strahlung an einem geeigneten Absorber, der sich an der zu behandelnden Unterseite des Substrates befindet, aufgefangen wird, und den restlichen Substratkörper nahezu ungehindert passiert.

Im Hinblick auf Wärmestrahler ist dies beispielsweise bei einseitig mit Metall beschichteten Glassubstraten der Fall, wie sie in der Solarzellenfertigung Verwendung finden. Umfassen derartige Zellen oder Module im Falle eines zumindest teilweise transparenten Substrates auch eine reflektierende und/oder absorbierende beispielsweise metallische Schicht, die zwischen dem Substrat und der zu erzeugenden sulfidischen wie z.B. CdS- oder ZnS-Schicht angeordnet ist, so erfolgt eine Absorption der Wärmestrahlung, die von der nicht zu behandelnden Seite eingestrahlt wird und den Substratkörper zumindest teilweise durchdringt, durch die reflektierende und/oder absorbierende Schicht selber. Dabei erwärmt sich diese Schicht, wodurch die Wärme gerade dort zur Verfügung gestellt wird, wo sie auch benötigt wird, nämlich direkt an der zu behandelnden Substratunterseite. Gleichzeitig verhindert diese Schicht ein Eindringen der Wärmestrahlung in die Behandlungsflüssigkeit, was erfindungsgemäß besonders erwünscht ist, da sonst der wärmeinduzierte Reaktionsprozess innerhalb der Flüssigkeit auch an anderer Stelle als direkt an der Substratoberfläche stattfinden könnte. Für den Fall eines für die Wärmestrahlung nicht transparenten Substratmaterials ist die Ausnutzung der ortsspezifischen Absorption demnach nicht gegeben; hier muss das Substrat als Ganzes erwärmt werden.

Vorzugsweise wird der mindestens eine Wärmestrahler daher aus der Gruppe bestehend aus langwelligen Infrarotstrahlern, Infrarotlasern und Mikrowellengeräten ausgewählt.

Der mindestens eine Wärmeübertrager wird bevorzugt aus der Gruppe bestehend aus heizbaren Platten, Walzen, Rollen, Bändern, Matten und Folien ausgewählt.

Wie bereits zuvor ausgeführt, kann die zur Abscheidung erforderliche Wärme erfindungsgemäß auch mittels Induktion wie z.B. elektromagnetischer Induktion erzeugt oder bereitgestellt werden. Unter elektromagnetischer Induktion versteht man das Entstehen einer elektrischen Spannung entlang einer Leiterschleife aufgrund der Änderung des magnetischen Flusses, beispielsweise durch das Anlegen eines bevorzugt niederfrequenten Wechselstromfeldes. Diese Flussänderung kann durch eine Lage- oder Formänderung der Leiterschleife im Magnetfeld, und/oder durch eine Änderung der Stärke oder Ausrichtung des Magnetfeldes hervorgerufen werden. Aufgrund der induzierten Spannung fließt ein Strom, welcher zu der gewünschten Erwärmung der Leiterschleife führt (induktive Erwärmung durch Wirbelstrom). Die erfindungsgemäß von dem zu modifizierenden Substrat umfasste Leiterschleife kann ein- oder mehrteilig ausgebildet sein und eine beliebige Form aufweisen sowie integraler Bestandteil oder aufgelagerte Komponente des Substrates sein. So können die Wärmeinduktoren zur erfindungsgemäßen Modifikation oder Beschichtung von rein metallischen Substraten als auch von ganzflächig oder teilflächig wie insbesondere streifen- oder punktförmig mit leitfähigen Materialien beaufschlagten Substraten eingesetzt werden.

Wärmeinduktoren bieten ähnliche Vorteile wie Wärmestrahler, wobei bei Vorhandensein eines metallischen Substrats (z.B. einer Metallplatte oder -folie) eine Volumenerwärmung erfolgt, wohingegen bei Vorhandensein lediglich einer metallischen Schicht auf dem ansonsten nichtleitenden Substrat ausschließlich diese metallische Schicht erwärmt wird. Insbesondere im zweiten Fall tritt weder eine Erwärmung des übrigen Substratmaterials noch der Behandlungsflüssigkeit auf, wenn man von der Sekundärerwärmung durch den Kontakt der metallischen Schicht mit dem restlichen Substrat und der Behandlungsflüssigkeit absieht. Letztere ist jedoch aufgrund der sehr effizienten Wärmeerzeugung sehr gering. Die Erzeugung der Wärme mittels Induktion weist außerdem eine Reihe weiterer Vorteile auf. So kann die zuzuführende Wärmemenge sehr genau dosiert werden, die Wärme wird besonders schnell und mit einem höheren Wirkungsgrad zugeführt, und es können auch eingebettete Schichten erwärmt werden, sofern das umgebene Material für die Induktionsstrahlung transparent ist.

Der mindestens eine Wärmeinduktor wird bevorzugt aus der Gruppe bestehend aus elektromagnetischen Induktionsspulen und elektromagnetischen Induktoren ausgewählt.

Im Rahmen der vorliegenden Erfindung wird eine Vorrichtung zur Durchführung des erfindungsgemäßen Verfahrens bereitgestellt.

Die Vorrichtung zur einseitigen nasschemischen Oberflächenmodifikation wie insbesondere Beschichtung eines im Wesentlichen flachen Substrates umfasst mindestens ein Behandlungsbecken zur Aufnahme von Behandlungsflüssigkeit, mindestens ein geeignetes Mittel zur Erwärmung der zu beschichtenden Substratunterseite auf die zur Ausbildung der gewünschten Schicht erforderliche Temperatur, sowie mindestens ein Mittel zur Auflage und Positionierung des Substrats mit seiner zu behandelnden Seite nach unten, wobei die Vorrichtung keine Mittel umfasst, mit denen das Substrat von oben gehalten oder geschützt werden kann. Das mindestens eine Mittel zur Erwärmung ist vorzugsweise aus der Gruppe bestehend aus Wärmestrahlern, Wärmeüberträgern, Wärmeinduktoren und Kombinationen derselben ausgewählt, wobei der mindestens eine Wärmestrahler besonders bevorzugt ausgewählt ist aus der Gruppe bestehend aus langwelligen Infrarotstrahlern, Infrarotlasern und Mikrowellengeräten, während der mindestens eine Wärmeüberträger besonders bevorzugt aus der Gruppe bestehend aus heizbaren Platten, Walzen, Rollen, Bändern, Matten und Folien ausgewählt ist, und der mindestens eine Wärmeinduktor bevorzugt aus der Gruppe bestehend aus elektromagnetischen Induktionsspulen und elektromagnetischen Induktoren ausgewählt ist. Vorzugsweise umfasst die Vorrichtung mindestens einen Wärmestrahler oder Wärmeinduktor, wobei aber auch mindestens ein Wärmeüberträger umfasst sein kann. Selbstverständlich sind auch Kombinationen der genannten Mittel zur Erwärmung möglich.

Das mindestens eine Mittel zur Erwärmung kann dabei sowohl außerhalb als auch innerhalb des Behandlungsbeckens oder der Behandlungsflüssigkeit angeordnet sein. Aus Gründen des Schutzes des Mittels zur Erwärmung ist jedoch eine Anordnung außerhalb des Behandlungsbeckens oder der Behandlungsflüssigkeit bevorzugt. Andererseits kann es vorteilhaft sein, das Mittel zur Erwärmung innerhalb des Behandlungsbeckens oder der Behandlungsflüssigkeit anzuordnen, um beispielsweise den Weg zwischen Mittel zur Erwärmung und der zu beschichtenden Substratunterseite möglichst kurz zu halten, oder weil eine ausschließliche Erwärmung der zu beschichtenden Substratoberfläche nicht möglich ist, da das restliche Substratmaterial für die Wärme- bzw. Induktionsstrahlung intransparent ist. Hier ist der Einsatz von Induktoren besonders bevorzugt, da die Behandlungsflüssigkeit, in der diese wahlweise auch eingebettet sein können, nicht induktiv erwärmbar ist, so dass sich die Temperatur der Behandlungsflüssigkeit trotz der Anordnung des Mittels zur Erwärmung innerhalb derselben nicht oder nur geringfügig ändert. Es ist daher bei einer Positionierung des mindestens einen Mittels zur Erwärmung innerhalb des Behandlungsbeckens oder der Behandlungsflüssigkeit zu gewährleisten, dass nur solche Mittel wie insbesondere Wärmeinduktoren zum Einsatz kommen, durch deren Aktivierung im Wesentlichen keine Erwärmung der Behandlungsflüssigkeit über ein vertretbares Maß hinaus erfolgt oder im Wesentlichen keine der im Stand der Technik beschriebenen unerwünschten Reaktionen (z.B. Kolloidbildung) induziert wird bzw. werden. Nach einer bevorzugten Ausführungsform ist das Behandlungsbecken so ausgestaltet, dass der vom Substrat kontaktierbare Oberflächenbereich der Behandlungsflüssigkeit hinsichtlich seiner Größe ungefähr demjenigen des zu beschichtenden Substrates entspricht, so dass die gesamte Fläche des Substrates gleichzeitig beschichtet werden kann. Das Becken kann zumindest geringfügig größer als die Substratbreite sein, wenn das Substrat vollständig (vollflächig) bis zum Rand beschichtet werden soll. Alternativ kann das Becken zumindest geringfügig, bevorzugt ca. 0,8 cm, kleiner als die Substratbreite sein, wenn das Substrat in einer entsprechend breiten Randzone nicht behandelt werden soll.

Nach einer vorteilhaften Ausführungsform umfasst die Vorrichtung ferner mindestens einen Einlass, durch den bevorzugt fortlaufend in das Behandlungsbecken einströmt, sowie mindestens eine Überlaufkante, über die die Behandlungsflüssigkeit vom Becken abgeführt und vorzugsweise in einen Auffangbehälter eingeleitet werden kann. Je nach Wehrhöhe der Überlaufkante ergibt sich eine unterschiedliche Abflussmenge an Behandlungsflüssigkeit aus dem Becken. Zum Flüssigkeitstransport kann bevorzugt eine Umwälzpumpe zum Einsatz kommen. Die Badtiefe des Behandlungsbeckens kann bevorzugt zwischen 1 mm und 40 mm betragen und besonders bevorzugt einstellbar sein. Außerdem kann die Badtiefe in Transportrichtung keilförmig ansteigend und/oder abfallend ausgestaltet sein. Dadurch können im Behandlungsbecken unterschiedliche und je nach Anwendungsfall vorteilhafte Strömungsverhältnisse erzeugt werden. Diese können außerdem durch eine Erhöhung oder Verringerung der Pumpleistung beeinflusst werden, so dass einer unerwünschten Veränderung der Zusammensetzung der Flüssigkeit im unmittelbaren Bereich der Substratoberfläche entgegen gewirkt werden kann. Im Auffangbehälter, in oder über dem sich das Behandlungsbecken bevorzugt befindet, wird die überschüssige Behandlungsflüssigkeit gesammelt und besonders bevorzugt wieder in einen entsprechenden Kreislauf eingebracht, so dass ein möglichst geringer Verbrauch an Behandlungsflüssigkeit erreicht wird.

Nach einer bevorzugten Ausführungsform umfasst die Vorrichtung ferner Sensoren, welche die Zusammensetzung und/oder die Temperatur der Behandlungsflüssigkeit erfassen und die Daten gegebenenfalls an eine nachgelagerte Regeleinrichtung weiterleiten kann, wobei diese Einrichtung bevorzugt von der Vorrichtung umfasst oder dieser funktionell zugeordnet ist. Diese Regeleinrichtung vergleicht den bzw. die gemessenen Istmit hinterlegten Sollwerte(n) und regelt nötigenfalls die Zusammensetzung bzw. Temperatur der Behandlungsflüssigkeit dergestalt nach, dass sie z.B. die Ventile eines Vorratsbehälters mit gekühlter Behandlungsflüssigkeit ansteuert. Nach einer bevorzugten Ausführungsform umfasst die Vorrichtung ferner mindestens ein Mittel zum Durchmischen der Behandlungsflüssigkeit, welches aus der Gruppe umfassend Schleppströmung, Konvektion, Ultraschall und/oder Düsen ausgewählt ist. Für ein homogenes Ergebnis ist es nämlich von besonderer Wichtigkeit, dass die Zusammensetzung und Konzentration der Behandlungsflüssigkeit im Behandlungsbad an jeder Stelle der Substratoberfläche möglichst gleich ist. Hierzu muss die vorgegebene in das Behandlungsbecken einströmende Behandlungsflüssigkeit nach Möglichkeit gut durchmischt werden, was bevorzugt durch die Bereitstellung entsprechender Mittel erfolgt. Diese erforderlichenfalls vorzunehmende Angleichung der Konzentration im Bad kann beispielsweise durch Temperaturkonvektion, wie auch bevorzugt beispielsweise durch die Unterstützung von Ultraschallsendern und/oder Düsen erfolgen, die in einer geeigneten Vorrichtung besonders bevorzugt in einer Vielzahl vorhanden sind und eine gleichmäßige Verteilung der einströmenden Flüssigkeit sicherstellen.

Nach einer bevorzugten Ausführungsform der Vorrichtung ist das mindestens eine Mittel zur Auflage des Substrats als mindestens ein Mittel zum Transport des Substrates während der Behandlung ausgeführt. Wie schon für den Fall ohne Substrattransport während der Behandlung erwähnt, ist bzw. sind diese Mittel derart ausgestaltet, dass sie das Substrat mit der zu behandelnden Seite nach unten positionieren, d.h. das Substrat liegt auf dem Transportmittel auf und ist über oder durch die Behandlungsflüssigkeit transportierbar. Ein wie auch immer gearteter Schutz der nicht zu behandelnden Seite des Substrates ist dabei nicht vorgesehen oder nötig. Gewünschtenfalls erfolgt die Positionierung des Substrates dabei so hoch über der Behandlungsflüssigkeit, dass eine Benetzung der Kanten des Substrates zumindest weitgehend vermieden wird.

Besonders bevorzugt kann das mindestens eine geeignete Transportmittel aus der Gruppe bestehend aus Transportrollen, Transportbändern und Transportriemen ausgewählt sein, wobei dieses Mittel bevorzugt eine Transportgeschwindigkeit des Substrates von etwa 10 cm/min bis etwa 3,0 m/min, und besonders bevorzugt von etwa 1,2 bis 1,5 m/min erzeugen kann. Durch die natürliche Schleppströmung der zu beschichtenden Oberfläche kann eine Durchmischung der Badflüssigkeit ohne weitere Hilfsmittel erreicht oder zumindest unterstützt werden. Im Falle eines beidseitig über den Beckenrand hinausragenden Substrates kann dieser Substratrand bevorzugt als Auflagefläche für das Transportmittel dienen. Nach einer besonders bevorzugten Ausführungsform des Transportmittels in der Form eines Transportbandes kann dieses auch als Dichtmittel zur Vermeidung einer unerwünschten Benetzung der umlaufenden Kante und/oder der Oberseite des Substrates dienen. Ferner kann hierdurch ein seitliches Übertreten von Behandlungsflüssigkeit in den Auffangbehälter vermieden werden. Durch eine bevorzugte Anpassung der Wehrhöhe der Überlaufkante an veränderte Transportgeschwindigkeiten kann der Verbrauch an Behandlungsflüssigkeit eingestellt werden.

Im Falle eines beabsichtigten kontinuierlichen Transportes des Substrates während der Behandlung ist das Behandlungsbecken bevorzugt so ausgestaltet, dass seine Breite, also seine horizontale Ausdehnung senkrecht zur Transportrichtung, ungefähr derjenigen des zu beschichtenden Substrates entspricht, so dass das Substrat gleichzeitig über seine gesamte Breite beschichtet werden kann. Für eine eventuell gewünschte unbehandelte Randzone gelten sinngemäß die vorstehenden Erläuterungen für den Fall einer Behandlung ohne Transport.

Nach einer bevorzugten Ausführungsform umfasst die Vorrichtung ferner mehrere unabhängig voneinander steuerbare Mittel zur Erwärmung des Substrates sowie eine Steuereinrichtung zur separaten Ansteuerung derselben. Dementsprechend ermöglicht die separate Ansteuerung die Erzeugung von Zonen unterschiedlicher Wärme- oder Leistungsabgabe auf das Substrat, während es den Mitteln zur Erwärmung ausgesetzt ist. Diese Zonen durchläuft das Substrat während des Transports, so dass jeder Ort auf der Substratunterseite ein vorherbestimmtes Temperaturprofil durchläuft oder erfährt. Hierbei ist jedoch sicherzustellen, dass das Temperaturprofil in einer senkrecht zur Transportrichtung liegenden Schnittebene des Substrates, insbesondere an dessen zu beschichtender Unterseite, weitgehend konstant ist.

Nach einer bevorzugten Ausführungsform erfolgt die gegebenenfalls bereichsweise Erwärmung des Substrates nur dann, wenn sich dieses über der Oberfläche der Behandlungsflüssigkeit befindet. Hierzu kann vorzugsweise mindestens ein Mittel zum Detektieren der Position des Substrates vorgesehen werden, welches der gezielten Ansteuerung der Mittel zur Erwärmung dient, indem nur diejenigen Erwärmungsmittel angesprochen werden, unter- bzw. oberhalb derer das Substrat sich gerade befindet. Somit kann erreicht werden, dass keine unerwünschte Erwärmung des unbedeckten Bades erfolgt. Die Mittel zum Detektieren der Position des Substrates sind vorzugsweise ausgewählt aus der Gruppe bestehend aus mechanischen Sensoren, optischen Sensoren und solchen, die mit der Transporteinrichtung gekoppelt sind. Letztere melden ohne eine konkrete Messung die erwartete Position des Substrates an die Ansteuerung, welche dann ihrerseits für eine entsprechende Schaltung der Mittel zur Erwärmung sorgt.

Nach einer bevorzugten Ausführungsform umfasst die Vorrichtung ferner ein Mittel zur Kühlung der Behandlungsflüssigkeit. Um den oben beschriebenen unerwünschten Effekten einer Erwärmung der Behandlungsflüssigkeit durch Wärmeabgabe der Substratoberfläche entgegen zu wirken, kann die Behandlungsflüssigkeit nach einer bevorzugten Ausführungsform passiv oder aktiv gekühlt werden. Als passive Kühlung können beispielsweise von der Behandlungsflüssigkeit durchströmbar ausgestaltete Kühlrippen vorgesehen werden. Allerdings ist deren Wirkungsgrad von der Umgebungstemperatur abhängig und daher insbesondere bei geringeren Temperaturunterschieden begrenzt. Daher sind aktive Kühlungen zu bevorzugen, bei denen mittels Wärmetauschern, die beispielsweise elektrisch antreibbar sind, größere Wärmemengen aus der Behandlungsflüssigkeit abgezogen werden können. Besonders bevorzugt können diese Wärmetauscher so im Flüssigkeitskreislauf angeordnet sein, dass die aus dem Behandlungsbecken ausströmende Flüssigkeit den Wärmetauscher durchläuft, bevor sie in das Becken zurückgeführt wird. Am meisten bevorzugt gelangt die rückgeführte, nunmehr gekühlte Flüssigkeit zunächst in einen Mischtank, in welchem nötigenfalls eine Wiederherstellung der gewünschten Zusammensetzung erfolgt, so dass dem Behandlungsbecken eine wohltemperierte und frische Behandlungsflüssigkeit zugeführt werden kann.

Um eine besonders gleich bleibende Wirkung der Mittel zur Erwärmung auf das Substrat zu erzielen, kann die Vorrichtung nach einer weiteren bevorzugten Ausführungsform ferner auch eine Vorheizeinrichtung umfassen, welche das Substrat vor dem eigentlichen Beschichtungsprozess auf eine definierte Temperatur erwärmt. Dadurch können beispielsweise Einflüsse unterschiedlicher Umgebungstemperaturen weitgehend ausgeglichen werden. Besonders bevorzugt ist die Vorheiztemperatur dabei so eingestellt, dass sie der oben erwähnten optimalen Starttemperatur des Beschichtungsprozesses entspricht.

Ferner kann die Vorrichtung eine Vorreinigungseinrichtung umfassen, welche dem eigentlichen Beschichtungsprozess und ggf. dem Vorheizschritt einen Reinigungsschritt beispielsweise zur Flitterreinigung vorschaltet, wenn dies erforderlich ist.

Nach der Beschichtung kann mit einer optional von der Vorrichtung umfassten Flüssigkeitsabtrenneinrichtung gegebenenfalls vorhandene überschüssige Behandlungsflüssigkeit von der Substratoberfläche beseitigt werden, was beispielsweise mittels Luftströmung erfolgen kann.

Ferner kann die Vorrichtung eine Spül- und/oder Trocknungseinrichtung umfassen, wodurch den zuvor beschriebenen Verfahrensschritten noch ein Spül- und/oder Trocknungsvorgang des Substrates nachgelagert wird.

Schließlich kann die Vorrichtung ferner eine oder mehrere Wendeeinrichtungen zur Durchführung von Wendeschritten umfassen, sofern das Substrat der Beschichtung zunächst mit der zu beschichtenden Seite nach oben zugeführt wird und/oder nach der Beschichtung in diese Lage überführt werden soll. Die hierfür zum Einsatz kommende Vorrichtung muss ein zügiges, sicheres und beschädigungsfreies Wenden des Substrates ermöglichen.

Das erfindungsgemäße Verfahren und die Vorrichtung wurden am Beispiel der einseitigen nasschemischen Beschichtung von flachen Substraten erläutert. Es ist jedoch klar, dass sowohl das erfindungsgemäße Verfahren als auch die Vorrichtung allgemein zur einseitigen nasschemischen Oberflächenmodifikation von flachen Substraten eingesetzt werden können, ohne die wesentlichen Merkmale der Erfindung zu verändern.

### Figurenbeschreibung

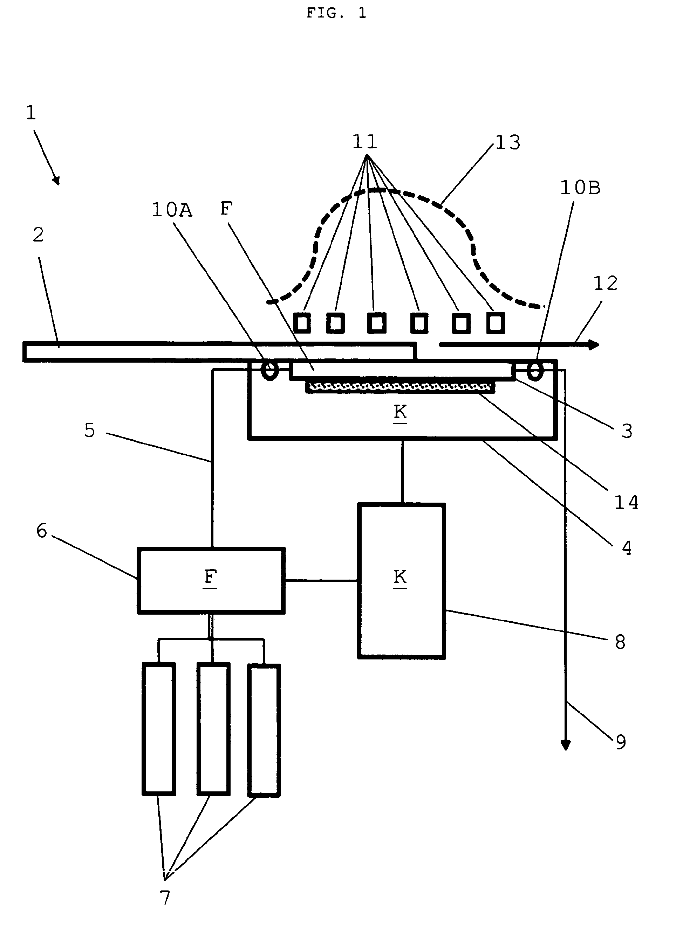

In Figur 1 sind schematisch die wesentlichen Merkmale der Vorrichtung 1 zur einseitigen nasschemischen Oberflächenmodifikation wie insbesondere zur Beschichtung flacher Substrate dargestellt.

Diese Figur zeigt ein flaches Substrat 2, welches sich teilweise oberhalb eines Behandlungsbeckens 3 befindet. Das Behandlungsbecken 3 ist mit Behandlungsflüssigkeit F gefüllt. Außerdem ist das Behandlungsbecken 3 in einem Kühlbecken 4 angeordnet. Das Kühlbecken 4 ist mit einer Kühlflüssigkeit K gefüllt, die dafür sorgt, dass die Temperatur im Behandlungsbecken 3 einer Solltemperatur entspricht, indem es Wärme aus dem Behandlungsbecken 3 aufnimmt und abführt. Durch entsprechende, in der Figur mittels dünner Linien dargestellte Leitungen 5 ist das Behandlungsbecken 3 mit einem Mischtank 6 verbunden. Dieser Mischtank wird von mehreren Reservoirs 7 gespeist, in denen sich die Bestandteile der Behandlungsflüssigkeit F befinden. Die Kühlflüssigkeit K wird durch ein Mittel zur Kühlung 8, mit dem sie fluidisch verbunden ist, auf einer gewünschten Kühltemperatur gehalten. Ebenfalls fluidisch verbunden sind das Mittel zur Kühlung 8 und der Mischtank 6, so dass eine Temperierung der im Mischtank 6 befindlichen, frischen Behandlungsflüssigkeit F möglich ist. Überschüssige oder verbrauchte Behandlungsflüssigkeit F kann aus dem Behandlungsbecken 3 über einen Abfluss 9 abfließen.

Die Höhe des Pegels der Behandlungsflüssigkeit kann über ein Wehr eingestellt werden, welches am Einlass (10A) und am als Überlaufkante (10B) ausgebildeten Ausgang des Behandlungsbeckens 3 angeordnet ist.

Oberhalb des Behandlungsbeckens 3 und somit des Substrats 2 sind Mittel zur Erwärmung 11 angeordnet. Die zum Betrieb derselben notwendigen elektrischen Leitungen usw. sind aus Gründen der Übersichtlichkeit nicht dargestellt, ebenso bevorzugt vorhandene Steuer- oder Regeleinrichtungen etc., sowie zum Fördern der Behandlungsflüssigkeit F oder der Kühlflüssigkeit K notwendige Pumpen.

Bei einem Fortbewegen des Substrats 2 in Transportrichtung 12 wird dieses von seiner nicht zu beschichtenden Oberseite her erwärmt. Dabei bildet sich in Abhängigkeit von der Einwirkdauer und der Höhe der eingestrahlten Leistung ein Temperaturprofil 13 aus, welches als gestrichelte Linie dargestellt ist. Bevorzugt ist das Temperaturprofil dabei über die gesamte Breite des Substrats 2 konstant, wobei sich die Substratbreite senkrecht zur Zeichenebene erstreckt.

Zu besseren Durchmischung der Behandlungsflüssigkeit F während des Durchlaufens des Substrats 2 sowie zum Abtransport etwaiger unerwünschter mittels des Substrates 2 erwärmter oberflächennaher Anteile der Behandlungsflüssigkeit F ist unterhalb des Behandlungsbeckens 3 ein Mittel zum Durchmischen 14 angeordnet, welches in der Figur als Ultraschallstrahler ausgebildet ist.

### Bezugszeichenliste

- 1: Vorrichtung
- 2: Substrat
- 3: Behandlungsbecken
- 4: Kühlbecken
- 5: Leitungen
- 6: Mischtank
- 7: Reservoir
- 8: Mittel zur Kühlung
- 9: Abfluss
- 10A: Einlass
- 10B: Überlaufkante
- 11: Mittel zur Erwärmung
- 12: Transportrichtung
- 13: Temperaturprofil
- 14: Mittel zum Durchmischen
- F: Behandlungsflüssigkeit, Flüssigkeit
- K: Kühlflüssigkeit

## Patentansprüche

1. Verfahren zur einseitigen nasschemischen Oberflächenmodifikation, wie insbesondere Beschichtung, eines flachen Substrates (2) unter Verwendung einer in einem Behandlungsbecken (3) befindlichen Flüssigkeit (F), deren chemische Bestandteile durch geeignete Temperatursteuerung auf der Substratfläche unter Ausbildung einer dauerhaften Schicht abgeschieden werden, bei dem die zur Ausbildung der gewünschten Schicht notwendige Erwärmung der zu beschichtenden Substratunterseite durch mindestens ein geeignetes Mittel zur Erwärmung (11) erfolgt, welches das Substrat (2) von seiner nicht zu beschichtenden Oberseite her auf die erforderliche Temperatur erwärmt, und bei dem die Oberseite während der Behandlung nicht mit einer wärmenden Flüssigkeit benetzt und das Substrat (2) nicht von oben gehalten oder geschützt wird.

2. Verfahren nach Anspruch 1, bei dem das Substrat (2) Glas, Metall und/oder Kunststoff umfasst und die Beschichtung im Rahmen der Herstellung von Dünnschicht-Solarzellen oder -modulen vorgenommen wird, und bei dem die Behandlungsflüssigkeit (F) Cadmium- oder Zinksulfat bzw. -acetat umfasst.

3. Verfahren nach Anspruch 1 oder 2, bei dem die Zusammensetzung und/oder die Temperatur der Behandlungsflüssigkeit (F) kontinuierlich überwacht und bei Bedarf nachgeregelt werden.

4. Verfahren nach einem der Ansprüche 1 bis 3, bei dem das Substrat (2) mit seiner zu beschichtenden unterseite während der Behandlung auf einem Transportmittel aufliegt und kontinuierlich über oder durch die Flüssigkeit (F) transportiert wird.

5. Verfahren nach einem der Ansprüche 1 bis 4, bei dem mehrere Mittel zur Erwärmung (11) des Substrates (2) eingesetzt werden, deren Leistung unabhängig voneinander gesteuert werden kann.

6. Verfahren nach einem der Ansprüche 1 bis 3, bei dem die Substratunterseite im Verlauf ihrer Beschichtung gleichmäßig auf unterschiedliche Temperaturen erwärmt wird.

7. Verfahren nach Anspruch 5, bei dem die Mittel zur Erwärmung (11) derart unabhängig voneinander gesteuert werden, dass die zu beschichtende Substratunterseite während ihres Transports über oder durch die Flüssigkeit (F) in Transportrichtung (12) ein vorgegebenes Temperaturprofil (13) durchläuft oder erfährt.

8. Verfahren nach Anspruch 7, bei dem das Temperaturprofil (13) in einer senkrecht zur Transportrichtung (12) liegenden Schnittebene des Substrates (2) weitgehend konstant ist.

9. Verfahren nach einem der Ansprüche 1 bis 8, bei dem das bzw. die Mittel zur Erwärmung (11) des Substrates (2) aus der Gruppe bestehend aus Wärmestrahlern, Wärmeüberträgern, Wärmeinduktoren und Kombinationen derselben ausgewählt wird.

10. Verfahren nach Anspruch 9, bei dem der oder die Wärmestrahler aus der Gruppe bestehend aus langwelligen Infrarotstrahlern, Infrarotlasern und Mikrowellengeräten ausgewählt wird bzw. werden.

11. Verfahren nach Anspruch 9, bei dem der oder die Wärmeüberträger aus der Gruppe bestehend aus heizbaren Platten, Walzen, Rollen, Bädern, Matten und Folien ausgewählt wird bzw. werden.

12. Verfahren nach Anspruch 9, bei dem der oder die Wärmeinduktoren aus der Gruppe bestehend aus Induktionsspulen und Induktoren ausgewählt wird bzw. werden.

## Claims

1. Method for the single-sided wet chemical surface modification, as in particular the coating, of a flat substrate (2) by using a liquid (F) being present in a treatment basin (3), wherein the liquid's chemical constituents are deposited onto the substrate surface under formation of a permanent layer by suitable temperature control, in which the heating of the substrate lower side to be coated being necessary for the formation of the desired layer is effected by at least one suitable means for heating (11) that heats the substrate (2) from its upper side not to be coated to the necessary temperature, and in which, during treatment, the upper side is not being wetted with a heating liquid and the substrate (2) is not being held from above or protected.

2. Method according to claim 1, wherein the substrate (2) comprises glass, metal, and/or plastic, and the coating is performed in the course of the production of thin film solar cells or modules, and wherein the treatment liquid (F) comprises cadmium or zinc sulphate or acetate, respectively.

3. Method according to claim 1 or 2, wherein the composition and/or the temperature of the treatment liquid (F) are continuously monitored, and readjusted if required.

4. Method according to one of claims 1 to 3, wherein during treatment the substrate (2) with its lower side to be coated rests on a transport means and is continuously transported over or through the liquid (F).

5. Method according to one of claims 1 to 4, wherein several means for heating (11) the substrate (2) are used, whose power can be controlled independently from each other.

6. Method according to one of claims 1 to 3, wherein the lower side of the substrate during its coating is uniformly heated to different temperatures.

7. Method according to claim 5, wherein the means for heating (11) are controlled independently from each other in such a manner that the substrate's lower side to be coated undergoes or experiences in transport direction (12) a predetermined temperature profile (13) during its transport over or through the liquid (F).

8. Method according to claim 7, wherein the temperature profile (13), in a substrate's (2) cutting plane being perpendicular to the transport direction (12), is to a large extent constant.

9. Method according to one of claims 1 to 8, wherein the means for heating (11) of the substrate (2) is/are selected from the group consisting of thermal radiators, thermal transfer devices, thermal inductors, and combinations thereof.

10. Method according to claim 9, wherein the thermal radiator(s) is/are selected from the group consisting of long-wave infrared radiators, infrared lasers, and microwave devices.

11. Method according to claim 9, wherein the thermal transfer device(s) is/are selected from the group consisting of heatable plates, cylinders, rollers, bands, mats, and foils.

12. Method according to claim 9, wherein the thermal inductor(s) is/are selected from the group consisting of induction coils and inductors.

## Revendications

1. Procédé pour la modification de surfaces d'un seul coté par traitement chimique en phase aqueuse, comme en particulier un revêtement, d'un substrat plan (2) utilisant un liquide (F) qui se trouve dans un bassin de traitement (3) dont les composés chimiques sont déposés sur la surface du substrat par un contrôle approprié de la température en formant une couche permanente, dans lequel le réchauffement nécessaire à la formation de la couche souhaitée pour revêtir la face inférieure à recouvrir est produit par au moins un dispositif de chauffage approprié (11), lequel chauffe le substrat (2) à la température nécessaire du coté de la face supérieure qui ne doit pas être recouverte, et dans lequel la face supérieure pendant le traitement n'est pas mouillée avec un liquide chauffant et le substrat (2) n'est pas tenu ou protégé par le haut.

2. Procédé selon la revendication 1 dans lequel le substrat (2) comprend le verre, les métaux et/ou les matières plastiques et le revêtement est effectué dans le cadre de la fabrication de cellules ou de modules photovoltaïques, et dans lequel le liquide de traitement (F) comprend du sulfate, respectivement de l'acétate de cadmium ou de zinc.

3. Procédé selon la revendication 1 ou 2 dans lequel la composition et/ou la température du liquide de traitement (F) est surveillé continuellement et peuvent être régulées au besoin.

4. Procédé selon l'une quelconque des revendications 1 à 3 dans lequel le substrat (2) est posé sur un dispositif de transport pendant le traitement sur la face inférieure à recouvrir et est transporté de manière continue sur ou à travers le liquide (F).

5. Procédé selon l'une quelconque des revendications 1 à 4 dans lequel plusieurs dispositifs de chauffage (11) du substrat (2) sont utilisés dont la puissance peut être régulée indépendamment les uns des autres.

6. Procédé selon l'une quelconque des revendications 1 à 3 dans lequel la face inférieure du substrat au cours de son traitement de revêtement est chauffée de manière uniforme à des températures différentes.

7. Procédé selon la revendication 5 dans lequel les dispositifs de chauffage (11) peuvent être régulés indépendamment les uns des autres de telle manière que la face inférieure du substrat à recouvrir pendant son transport sur ou à travers le liquide (F) parcourt ou subit un profil de température (13) prédéterminé dans le sens du transport (12).

8. Procédé selon la revendication 7 dans lequel le profil de température (13) est dans une large mesure constant sur un plan sécant du substrat perpendiculaire au sens du transport (12).

9. Procédé selon l'une quelconque des revendications 1 à 8 dans lequel le ou les dispositifs de chauffage (11) du substrat (2) sont choisis dans le groupe constitué par des chauffages rayonnants, transmetteurs de chauffage, inducteurs chauffants et des combinaisons de ceux-ci.

10. Procédé selon la revendication 9 dans lequel le ou les chauffages rayonnants sont choisis dans le groupe constitué par des appareils à rayon infrarouge à longues ondes, lasers à infrarouge et appareils à micro-ondes.

11. Procédé selon la revendication 9 dans lequel le ou les transmetteurs de chauffage sont choisis dans le groupe constitué par des plaques, cylindres, rouleaux, bandes, tapis et feuilles chauffants.

12. Procédé selon la revendication 9 dans lequel les inducteurs chauffants sont choisis dans le groupe constitué par des bobines à induction et des inducteurs.
